# EUROPEAN PATENT APPLICATION

(11) **EP 3 199 663 A1**
(43) Date of publication of application: **02.08.2017**
(21) Application number: 17152906.8
(22) Date of filing: 24.01.2017
(51) Int. Cl.: C23C 16/02, C23C 16/18, C23C 16/34, C23C 16/452, C23C 16/455

(54) **APPARATUS AND METHOD FOR FORMING METAL FILM BY HOT-WIRE ASSISTED CLEANING AND ATOMIC LAYER DEPOSITION**

(30) Priority: 01.02.2016 CN 201610070694
(71) Applicant: Semiconductor Manufacturing International Corporation (Shanghai), Shanghai 201203 (CN); Semiconductor Manufacturing International Corporation (Beijing), Beijing 100176 (CN)
(72) Inventor: YUAN, Guangjie, Shanghai, 201203 (CN); ZHOU, Junqing, Shanghai, 201203 (CN); ZHANG, Haiyang, Shanghai, 201203 (CN)
(74) Representative: Klunker IP Patentanwälte PartG mbB

(57) **Abstract**

An apparatus includes a housing, a chamber disposed in the housing and configured to receive a substrate, a shower head disposed outside the housing and configured to supply a process gas to the chamber, and a hot wire at a first temperature disposed between the shower head and the substrate. The hot wire at the first temperature ionizes the process gas, and the ionized gas is supplied to the substrate for performing a hot-wire assisted plasma-assisted precleaning process and a hot-wire assisted atomic layer deposition process. The apparatus also includes a hot plate in the chamber and configured to bring the substrate to a second temperature.

## Description

### CROSS-REFERENCES TO RELATED APPLICATIONS

This application claims priority to Chinese patent application No. 201610070694.5, filed on February 01, 2016.

### BACKGROUND OF THE INVENTION

Embodiments of the present invention relate to the field of semiconductor device fabrication. In particular, embodiments of the present invention relate to an apparatus and method for manufacturing a semiconductor device with a hot-wire assisted atomic layer deposition.

As the feature sizes of semiconductor process nodes continuously shrink, there is a need to lower the resistivity and improve the adhesion of the nucleation layer. On the other hand, because the physical vapor deposition (PVD) process has a relatively poor step coverage, thus, with the decrease of critical dimensions, the atomic layer deposition (ALD) process has replaced the PVD process to obtain a good conformal deposition.

Although the ALD process has a near 100% step coverage, it is, however, difficult to avoid impurities, i.e., halogen, oxygen, carbon, or the like from forming on processed layers. The impurities will adversely affect the electrical and electromagnetic characteristics of a device. In the conventional manufacturing process of mainstream technological nodes, advanced pre-cleaning (APC) techniques have been used to remove polymer and metal oxide residues (e.g., copper) after a wet etch process. However, the use of plasma pre-cleaning of the APC processes may damage the low-k dielectric layer.

Thus, there is a need for an apparatus and method for manufacturing a semiconductor device that can solve these problems.

### BRIEF SUMMARY OF THE INVENTION

The present inventors propose the following apparatus and method for manufacturing a semiconductor device to solve the aforementioned deficiencies.

According to a first aspect of the present invention, an apparatus includes a housing, a chamber disposed in the housing and configured to receive a substrate, a shower head disposed outside the housing and configured to supply a process gas to the chamber, and a hot wire at a first temperature disposed between the shower head and the substrate. The hot wire is configured to, at the first temperature, ionize the process gas, and the apparatus is configured so that the ionized gas is supplied to the substrate for performing a hot-wire assisted plasma-assisted pre-cleaning process and a hot-wire assisted atomic layer deposition process.

Preferably, the apparatus also includes a hot plate in the chamber that is configured to heat the substrate at a second temperature. Preferably, the second temperature is in a range between 150 °C and 400 °C

Preferably, the apparatus further includes an exhaust device configured to suck a gas of the chamber and discharge the sucked gas to an outside of the housing, and a pressure control device configured to control a pressure of the chamber.

The process gas may include nitrogen, hydrogen, or a combination of nitrogen and hydrogen. Preferably, the first temperature of the hot wire is in the range between 900 °C and 1700 °C during the hot-wire assisted and plasma-assisted pre-cleaning process.

The process gas may include an ammonia gas and a precursor gas containing a metal element. Preferably, the first temperature of the hot wire is in the range between 900 °C and 1700 °C during the hot-wire assisted atomic layer deposition process.

Preferably, the precursor gas comprises Ta[N(CH₃)₂]₅, Ru(C₅H₅)₂, or Co(C₅H₅)₂.

Preferably, the chamber has a pressure less than 1 Torr when the hot-wire assisted and plasma-assisted pre-cleaning process and the hot-wire assisted atomic layer deposition process are performed.

A second aspect of the present invention provides a method for manufacturing a semiconductor device. The method includes: (a) providing a substrate comprising a dielectric layer and a conductive layer in the dielectric layer, the conductive layer having an exposed upper surface; (b) forming an interlayer dielectric layer having an opening exposing a portion of the exposed upper surface of the conductive layer; (c) performing a hot-wire assisted plasma-assisted pre-cleaning process on the substrate; (d) after the pre-cleaning process has been performed, performing a hot-wire assisted atomic deposition process to form a buffer barrier layer on the exposed portion of the upper surface of the conductive layer and on sidewalls of the opening; and (e) forming a metal material on the buffer barrier layer and filling the opening.

Preferably, the buffer barrier layer includes: a barrier layer configured to prevent the metal material from diffusing into the conductive layer and the interlayer dielectric layer, and a buffer layer on the barrier layer and configured to increase adhesion between the barrier layer and the metal material. Preferably, the barrier layer is made of TaN. Performing the hot-wire assisted atomic deposition process may include: a process gas comprising an ammoniac gas and a precursor containing tantalum (Ta), a hot wire at a temperature in a range between 900 °C and 1700 °C. The precursor includes Ta[N(CH₃)₂]₅.

The buffer layer may be made of rubidium (Ru). Preferably, performing the hot-wire assisted atomic deposition process includes: a process gas comprising an ammoniac gas and a precursor containing rubidium (Ru), and a hot wire at a temperature in the range between 900 °C and 1700 °C. Preferably, the precursor includes Ru(C₅H₅)₂.

The buffer layer may be made of cobalt (Co). Preferably, performing a hot-wire assisted atomic deposition process includes: a process gas comprising an ammoniac gas and a precursor containing cobalt (Co), and a hot wire at a temperature in the range between 900 °C and 1700 °C. The precursor includes Co(C₅H₅)₂.

The barrier layer may be made of tantalum nitride (TaN), and the buffer layer is made of cobalt (Co) or rubidium (Ru).

Preferably, forming the metal material includes forming a metal seed layer on the buffer layer, and plating a metal layer on the metal seed layer and filling the opening.

Preferably, forming the interlayer dielectric layer includes forming a first interlayer dielectric layer made of a nitrogen-doped silicon carbide layer, and forming a second interlayer dielectric layer made of a silicon-containing organic low-k dielectric layer on the first interlayer dielectric layer.

Preferably, performing the hot-wire assisted plasma-assisted pre-cleaning process includes: providing a process gas comprising hydrogen or nitrogen and hydrogen, ionizing the process gas using a hot wire at a first temperature in the range between 900 °C and 1700 °C, and providing the ionized process gas to the substrate for cleaning the exposed portion of the upper surface of the conductive layer.

Preferably, the method further includes providing the substrate on a hot plate at a second temperature in the range between 150 °C and 400 °C when performing the hot-wire assisted plasma-assisted pre-cleaning process and the hot-wire assisted atomic deposition process.

Preferably, performing the hot-wire assisted atomic deposition process includes: providing a process gas comprising an ammoniac gas and a precursor gas containing a metal element, ionizing the process gas using a hot wire having a temperature in a range between 900 oC and 1700 oC, and providing the ionized process gas to the substrate to form the buffer barrier layer.

Preferably, providing the process gas includes: four stages having a first stage providing helium and a precursor gas containing a metal element, a second stage providing helium, a third stage providing ammonia (NH₃), and a fourth stage providing helium.

An apparatus according to the first aspect of the present invention may be operated or may operate according to a method according to the second aspect of the present invention.

The following description, together with the accompanying drawings, will provide a better understanding of the nature and advantages of the claimed invention.

### BRIEF DESCRIPTION OF THE DRAWINGS

The accompanying drawings, referred to herein and constituting a part hereof, illustrate embodiments of the invention. The drawings together with the description serve to explain the principles of the invention.
FIG. 1 is a schematic diagram illustrating a semiconductor manufacturing apparatus according to an embodiment of the present invention.
FIG. 2 is a schematic diagram illustrating a semiconductor manufacturing apparatus according to another embodiment of the present invention.
FIGS. 3 through 8 are cross-sectional views of intermediate stages of a manufacturing method according to some embodiments of the present invention.
FIG. 9 is a flowchart illustrating a manufacturing method according to an embodiment of the present invention.

### DETAILED DESCRIPTION OF THE INVENTION

In the following description, numerous specific details are provided for a thorough understanding of the present invention. However, it should be appreciated by those of skill in the art that the present invention may be realized without one or more of these details. In other examples, features and techniques known in the art will not be described for purposes of brevity.

It should be understood that the drawings are not drawn to scale, and similar reference numbers are used for representing similar elements. Embodiments of the invention are described herein with reference to perspective cross-section illustrations that are schematic illustrations of idealized embodiments (and intermediate structures) of the invention. The thickness of layers and regions in the drawings may be exaggerated relative to each other for clarity. Additionally, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

It will be understood that, when an element or layer is referred to as "on," "disposed on," "adjacent to," "connected to," or "coupled to" another element or layer, it can be disposed directly on the other element or layer, adjacent to, connected or coupled to the other element or layer, or intervening elements or layers may also be present. In contrast, when an element is referred to as being "directly on," directly disposed on," "directly connected to," or "directly coupled to" another element or layer, there are no intervening elements or layers present between them. It will be understood that, although the terms "first," "second," "third," etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

The use of the terms first, second, etc. do not denote any order, but rather the terms first, second, etc. are used to distinguish one element from another. Furthermore, the use of the terms a, an, etc. does not denote a limitation of quantity, but rather denote the presence of at least one of the referenced items.

The term "substrate" may include any structure having an exposed surface with which to form an integrated circuit. The term "substrate" is understood to include semiconductor wafers and is also used to refer to semiconductor structures during processing and may include other layers that have been fabricated thereupon. A "substrate" may include doped and undoped semiconductor wafers, epitaxial semiconductor layers, as well as other semiconductor structures.

As described in the background section, the present inventors discovered that is not easy to prevent impurities (i.e., halogen, oxygen, carbon, or the like) from forming on processed layers. The impurities will adversely affect the electrical and electromagnetic characteristics of a device. Thus, the present inventors propose following solutions: an apparatus and method for manufacturing a semiconductor device that can prevent impurities from forming on processed layers.

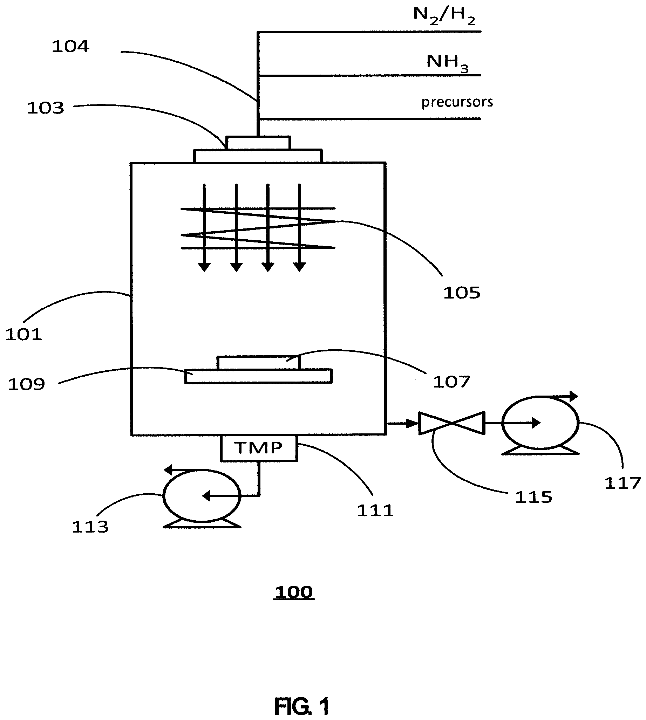

In accordance with some embodiments of the present invention, FIG. 1 is a schematic diagram illustrating a semiconductor manufacturing apparatus 100. Apparatus 100 includes a housing 101 forming a closed chamber configured to receive a substrate 107 that is to be processed.

Apparatus 100 also includes a shower head 103 disposed on housing 101 and configured to supply a gas externally to the interior of the chamber. In some embodiments, the gas may include a process gas. In other embodiments, the gas may include a process gas and a carrier gas. Preferably, the temperature of the gas is in the range between 80 °C and 110 °C, e.g., 100 °C. Depending on applications, the process gas may include hydrogen or nitrogen and hydrogen. The process gas may also include an ammonia gas and a precursor gas containing a metal element. The precursor gas may include different metal compounds, e.g., pentakis (dimethylamino) tantalum (V) (PDMAT), Co(C₅H₅)₂, Ru(C₅H₅)₂, or the like. The carrier gas may be helium (He) and other inert gases.

Apparatus 100 further includes a hot wire 105 disposed between shower head 103 and the to-be-processed substrate 107. In operations, hot wire 105 is brought to a predetermined temperature. As an example, in some embodiments, the temperature of the hot wire may be in the range between 900 °C and 1700 °C, such as 1350 °C. A gas provided by the shower head flows through the hot wire, as indicated by arrows in FIG. 1. The hot wire ionizes the gas (e.g., the process gas). It is understood herein that the gas is not necessary to be in direct contact with the hot wire in order to be ionized. The gas receiving heat radiation from the hot wire may also be ionized. The ionized gas is supplied to the to-be-processed substrate 107, for example, in order to perform a hot wire assisted plasma-assisted pre-wash or a hot wire assisted atomic layer deposition.

The hot wire may be made of different materials depending on apparatus applications or replacements. For example, the hot wire may be made of tungsten, ruthenium, titanium, or other material. It should be understood that the mentioned materials are merely exemplary and not limiting. The hot wire may have different shapes, e.g., a polygon shape, a circular shape, a spiral shape, a grid-like shape, or any irregular shape. Preferably, the hot wire has a meandering shape or a zigzag shape.

Apparatus 100 may also include a hot plate 109 disposed in the chamber and configured to support and heat the to-be-processed substrate 107. In certain embodiments, the hot plate may have a temperature in the range from 150 °C and 400 °C, e.g., 250 °C. In addition, apparatus 100 may include a controller (not shown) configured to control the temperature of the hot wire and the hot plate.

Apparatus 100 may also include one or more exhaust devices 111 and 113 configured to suck an exhaust gas in the chamber and discharge the sucked gas to the outside of the housing. In the example shown in FIG. 1, the exhaust device 113 may include a variety of suitable pumps, e.g., a turbo-molecular pump (TMP) 111 and/or a rotary fluid pump 113. The turbo-molecular pump (TMP) is preferably used to control the degree of vacuum in the housing to remove oxygen and reaction by-products from the housing. It is possible to achieve a high vacuum below about 10⁻⁵ Pa with the turbo-molecular pump to completely remove oxygen and other reaction byproducts from the chamber.

Apparatus 100 may also include other additional or alternative pressure control members for controlling the housing pressure. In the example shown in FIG. 1, the air pressure control member may include a pressure controller 115 and a pump 117. Pressure controller 115 is configured to measure the pressure of the housing, and control pump 177 is configured to control the pressure of the housing based on the measured pressure.

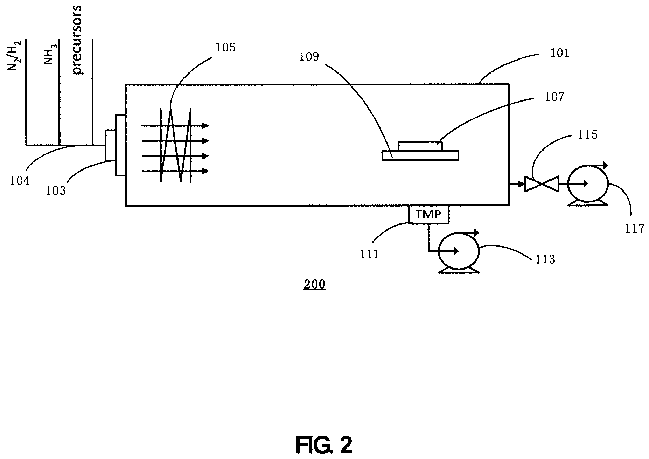

FIG. 2 is a schematic diagram illustrating a semiconductor manufacturing apparatus 200 according to another embodiment of the present invention. Apparatus 200 is similar to apparatus 100, therefore, apparatus 200 includes components having the same reference numerals as those of apparatus 100. Apparatus 200 differs from apparatus 100 in that shower head 103, hot wire 105 and the to-be-processed substrate 107 are arranged horizontally in apparatus 200. In contrast, shower head 103, hot wire 105 and the to-be-processed substrate 107 are arranged vertically in apparatus 100. The distance between the hot wire (ion source) and the to-be-processed substrate in apparatus 200 is greater than the distance between the hot wire (ion source) and the to-be-processed substrate in apparatus 100.

Thus, the embodiment shown in FIG. 2 has a better temperature control over the to-be-processed substrate, so that the temperature of the substrate will not be increased in the deposition process. It is noted that the present invention does not impose a special requirement on the distance between the hot wire and the substrate (or the hot plate carrying the substrate), as long as the temperature of the substrate does not increase in the deposition process. A too high temperature of the substrate may lead to a decomposition of a source gas in the adsorption process, resulting in the deposition similar to the CVD process, but not to the self-limiting nature of the ALD process.

A hot-wire assisted pre-cleaning (HW-APC) process and/or hot wire assisted atomic layer deposition (HW-ALD) process may be performed in apparatus 100 or 200 according to embodiments of the present invention.

When apparatus 100 or 200 is used in a HW-APC process, the process gas may be hydrogen or nitrogen and hydrogen. The flow rate of the hydrogen gas may be, for example, 30 sccm. There is no particular constraint on the flow rate of the nitrogen and hydrogen, e.g., the flow rate of nitrogen and hydrogen may be 30 sccm. There is no particular constraint on the ratio of nitrogen to hydrogen. The nitrogen and hydrogen ratio may be in the range between 0 and 1. The temperature of the hot wire may be in the range between 900 °C and 1700 °C, e.g., 1350 °C. The process gas can be supplied to the substrate after being ionized by the hot wire. In other words, the process gas comprising hydrogen or nitrogen and hydrogen, after being ionized at a temperature between 900 °C and 1700 °C, will reach the to-be-processed substrate. Preferably, the housing pressure is less than 1 Torr, e.g., 0.2 Torr. Alternatively, the temperature of the hot plate may be in the range between 150 °C and 400 °C, e.g., 250 °C. The hot plate is configured to heat the substrate and its close proximity to a temperature that is substantially equal to the temperature of the hot plate.

When tantalum nitride (TaN) is deposited using the hot wire assisted atomic layer deposition (HW-ALD) process in the apparatus, the process gas may include pentakis (dimethylamino) tantalum (V) (Ta[N(CH₃)₂]₅, PDMAT) and ammonia (NH₃), where PDMAT is a precursor, NH₃ is a reaction gas in reaction with the precursor. Helium (He) can be used as a carrier. In an embodiment, the HW-ALD process can be carried out in four stages. Helium and PDMAT, helium, NH₃, and helium may be provided through the shower head into the housing in four respective stages. Specifically, the first stage includes He and PDMAT, the second stage includes He, the third stage includes NH3, and the fourth stage includes He. The reaction temperature is 250 °C, and the reaction pressure is 0.2 Torr. In a specific embodiment, the flow rate of helium and PDMAT, helium, NH3, and helium is 30 sccm, respectively. The purity of the HW-ALD TaN is greater than 99%. The temperature of the hot wire may be between 900 °C and 1700 °C. The process gas may reach the substrate after being ionized by the hot wire. In other words, the process gas, after being ionized by the hot wire at a temperature between 900 °C and 1700 °C, is supplied to the substrate. Preferably, the hot plate has a temperature in the range between 150 °C and 400 °C, e.g., 250 °C, so that the reaction temperature is substantially equal to the temperature of the substrate, e.g., 250 °C. Preferably, the pressure of the chamber may be less than 1 Torr, e.g., 0.2 Torr.

When cobalt (Co) is deposited using the hot wire assisted atomic layer deposition (HW-ALD) process in the apparatus, the process gas may include Co(C₅H₅)₂ and NH₃, where Co(C₅H₅)₂ is a precursor, NH₃ is a reaction gas in reaction with the precursor. In an embodiment, the HW-ALD process can be carried out in four stages. Helium and Co(C₅H₅)₂, helium, NH₃, and helium may be provided through the shower head into the housing in four respective stages. The reaction temperature is 250 °C, and the reaction pressure is 0.2 Torr. In a specific embodiment, the flow rate of and Co(C₅H₅)₂, helium, NH₃, and helium may be 30 sccm, respectively. The purity of the HW-ALD is greater than 99%. The temperature of the hot wire may be between 900 °C and 1700 °C. The process gas may reach the substrate after being ionized by the hot wire. In other words, the process gas, after being ionized by the hot wire at a temperature between 900 °C and 1700 °C, is supplied to the substrate. Preferably, the hot plate has a temperature in the range between 150 °C and 400 °C, e.g., 250 °C, so that the reaction temperature is substantially equal to the temperature of the substrate, e.g., 250 °C. Preferably, the pressure of the chamber may be less than 1 Torr, e.g., 0.2 Torr.

When ruthenium (Ru) is deposited using the hot wire assisted atomic layer deposition (HW-ALD) process in the apparatus, the process gas may include Ru(C₅H₅)₂ and NH₃, where Ru(C₅H₅)₂ is a precursor, NH₃ is a reaction gas in reaction with the precursor. In an embodiment, the HW-ALD process can be carried out in four stages. Helium and Ru(C₅H₅)₂, helium, NH₃, and helium may be provided through the shower head into the housing in four respective stages. In a specific embodiment, the flow rate of and Ru(C₅H₅)₂, helium, NH3, and helium may be 30 sccm, respectively. The purity of Ru is greater than 99%. The temperature of the hot wire may be between 900 °C and 1700 °C. The process gas may reach the substrate after being ionized by the hot wire. In other words, the process gas, after being ionized by the hot wire at a temperature between 900 °C and 1700 °C, is supplied to the substrate. Preferably, the hot plate has a temperature in the range between 150 °C and 400 °C, e.g., 250 °C, so that the reaction temperature is substantially equal to the temperature of the substrate, e.g., 250 °C. Preferably, the pressure of the chamber may be less than 1 Torr, e.g., 0.2 Torr.

Similarly, during the HW-ALD process, there is no specific constraints on the gas flow rate and the gas flow ratio of each component. The gas flow rate and the gas flow rate ratio can be selected as desired by those of skill in the art.

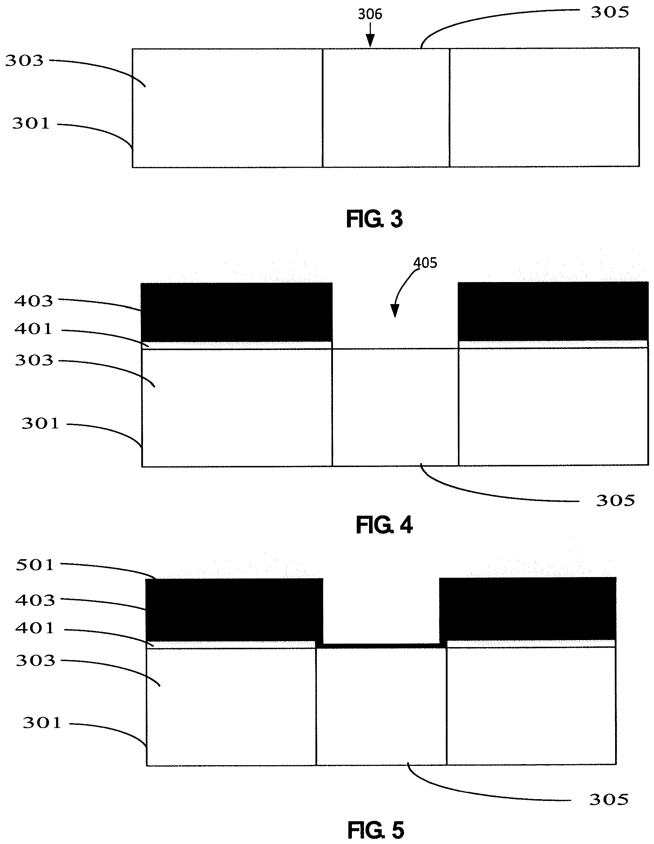

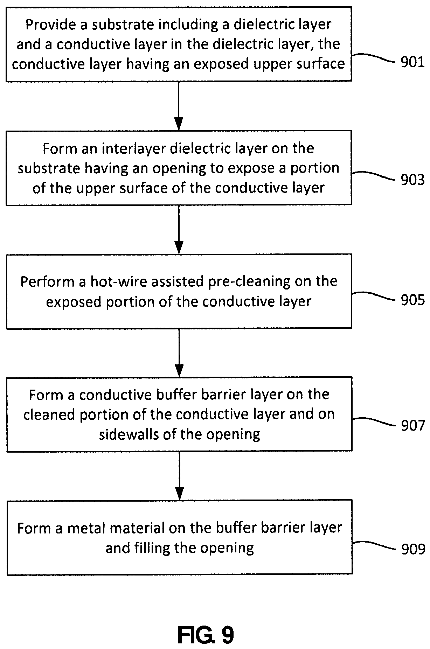

FIGS. 3 through 8 are cross-sectional views of intermediate stages of a manufacturing method according to some embodiments of the present invention. FIG. 9 is a flowchart illustrating a manufacturing method according to an embodiment of the present invention.

Referring to FIG. 9, in step 901 a substrate is provided. The substrate may include a dielectric layer and a conductive layer within the dielectric layer and having an exposed surface. As shown in FIG. 3, substrate 301 includes a dielectric layer 303 and a conductive layer 305 disposed within dielectric layer 303. Conductive layer 305 includes an exposed upper surface 306. Preferably, the exposed surface of the conductive layer is flush (coplanar) with the upper surface of the dielectric layer. Conductive layer 305 may include one or more conductive plugs, one or more metal wires, and other wiring layers.

Next, referring to FIG. 9, in step 903, an interlayer dielectric layer is formed on the substrate, the interlayer dielectric layer having an opening exposing at least a portion of the conductive layer. As shown in FIG. 4, an interlayer dielectric layer is formed on the substrate. In a specific embodiment, the interlayer dielectric layer includes a first dielectric layer 401 and a second dielectric layer 403. First dielectric layer 401 may be formed, for example, of N-doped silicon carbide (NDC). Second dielectric layer 403 may be formed of a low-k silicon-containing organic material, e.g., a SiCOH (also referred to as black diamond) material. It is, however, understood that embodiments of the present invention are not limited thereto. The interlayer dielectric layer has an opening 405 exposing at least a portion of the upper surface of conductive layer 305.

Next, referring to FIG. 9, in step 905, a hot-wire assisted pre-cleaning (HW-APC) process is performed on the exposed portion of the conductive layer. For example, the HW-APC process may be performed by providing the substrate into the chamber of the above-described apparatus and supplying a process gas using the shower head into the housing of the apparatus. As described above, the process gas for the HW-APC process may include hydrogen or nitrogen and hydrogen. The process gas is ionized by the hot wire that has a temperature in the range between 900 °C and 1700 °C. The ionized process gas is provided to the substrate to carry out the HW-APC process. Preferably, in the hot-wire assisted pre-cleaning (HW-APC) process, the substrate is disposed on the hot plate having a temperature in the range between 150 °C and 400 °C, e.g., 250 °C. Preferably, the pressure of the housing is less than 1 Torr, e.g., 0.2 Torr.

Referring to FIG. 9, in step 907, after the pre-cleaning (HW-APC) process, a conductive buffer barrier layer is formed on the exposed portion of the conductive layer and on sidewalls of the opening. In certain embodiments, the buffer barrier layer may include a barrier layer for preventing diffusion of a metallic material and a buffer layer disposed on the barrier layer for increasing adhesion between the barrier layer and the metal material. For example, the HW-APC process may be performed using the above-described apparatus and the associated processes. Thereafter, in step 909, a metal material is formed on the buffer barrier layer. As an example, FIGS. 5 through 8 illustrate cross-sectional views of intermediate stages of a manufacturing method of steps 907 and 909 in FIG. 9.

Referring to FIG. 5, after the pre-cleaning process, a conductive barrier layer 501 is formed on the structure as shown in FIG. 4 that is obtained after the hot wire assisted atomic layer deposition (HW-ALD) process has been performed in the apparatus. Conductive barrier layer 501 is formed on the exposed portion of conductive layer 305, on the sidewalls of opening 405, and on the surface of second dielectric layer 403. In a specific embodiment, conductive barrier layer 501 may be made of TaN using the hot wire assisted atomic layer deposition (HW-ALD) process. The hot wire assisted atomic layer deposition (HW-ALD) process may include a process gas including ammonia and a precursor gas (e.g., PDMAT) containing a metal element (e.g., Ta), the temperature of the hot wire is in the range between 900 °C and 1700 °C. The process gas is provided to the substrate after being ionized by the hot wire. Preferably, in the hot-wire plasma-assisted pre-cleaning process, the substrate is disposed on the hot plate having a temperature in the range between 150 °C and 400 °C, e.g., 250 °C. Preferably, the pressure of the chamber into which the substrate is provided is less than 1 Torr, e.g., 0.2 Torr.

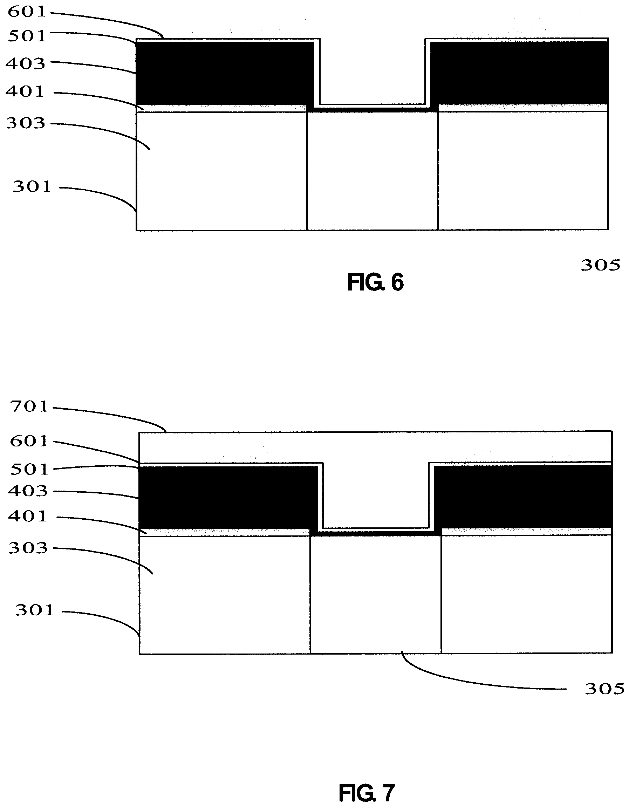

Next. referring to FIG. 6, a buffer layer 601 is formed on conductive barrier layer 501. In an embodiment, buffer layer 601 is made of Co or Ru and by the above-described wire assisted atomic layer deposition process. For example, the hot wire assisted atomic layer deposition process may include a process gas including ammonia and a precursor gas (e.g., Co(C₅H₅)₂ or Ru(C₅H₅)₂) containing a metal element (e.g., Co or Ru), the temperature of the hot wire is in the range between 900 °C and 1700 °C. The process gas is provided to the substrate after being ionized by the hot wire. Preferably, in the hot-wire atomic layer deposition (HW-ALD) process, the substrate is disposed on the hot plate within the chamber having a temperature in the range between 150 °C and 400 °C, e.g., 250 °C. Preferably, the pressure of the chamber where the substrate is provided into is less than 1 Torr, e.g., 0.2 Torr.

Next. referring to FIG. 7 and FIG. 9, a metal material 701 is formed on barrier layer 601 to fill opening 405 in step 909. Herein, metal material 701 may be obtained by forming a metal seed layer (e.g., copper, tungsten, aluminum, etc.) on the buffer layer, and then plating a metal layer having the same metal material as that of the seed metal layer on the seed layer to fill the opening.

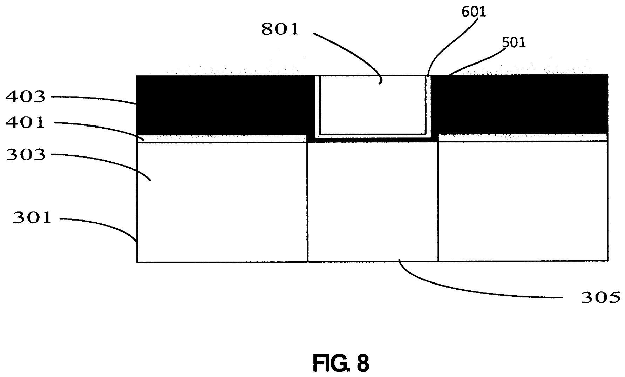

Next. referring to FIG. 8, a planarization (e.g., a chemical mechanical polishing or back-etch) process is performed on the structure shown in FIG. 7 to remove unwanted portions of the conductive buffer layer and a portion of the metal material outside of the opening. A conductive structure filling the opening is thus formed. The conductive structure includes a conductive buffer layer (501 and 601) disposed on the surface of conductive layer 305 and sidewalls of opening 405, and a conductive material 801 disposed on the conductive buffer layer.

Those of skill in the art will appreciate that steps 907 and 909 of FIG. 9 are example embodiments of the present invention, and are not limiting. These and other variations, modifications, and alternatives will be apparent by those of skill in the art.

## Claims

1. An apparatus comprising:
a housing;
a chamber disposed in the housing and configured to receive a to-be-processed substrate;
a shower head disposed outside of the housing and configured to supply a process gas to the chamber; and
a hot wire at a first temperature and disposed between the shower head and the substrate,
wherein the hot wire is configured to ionize the process gas, and
wherein the apparatus is configured so that the ionized gas is supplied to the substrate for performing a hot-wire assisted plasma-assisted pre-cleaning process and a hot-wire assisted atomic layer deposition process.

2. The apparatus of claim 1, further comprising:
a hot plate disposed in the chamber and configured to heat the substrate to a second temperature;
wherein preferably: the second temperature is in a range between 150 °C and 400 °C.

3. The apparatus of claim 1 or 2, further comprising:
an exhaust device configured to suck a gas of the chamber and discharge the sucked gas to an outside of the housing; and
a pressure control device configured to control a pressure of the chamber.

4. The apparatus of any one of the claims 1-3, wherein
the process gas comprises nitrogen, hydrogen, or a combination of nitrogen and hydrogen, and the first temperature of the hot wire is in a range between 900 °C and 1700 °C when the hot-wire assisted and plasma-assisted pre-cleaning process is performed; or the process gas comprises an ammonia gas and a precursor gas containing a metal element, and the first temperature of the hot wire is in the range between 900 °C and 1700 °C when the hot-wire assisted atomic layer deposition process is performed, wherein preferably: the precursor gas comprises Ta[N(CH₃)₂]₅, Ru(C₅H₅)₂, or Co(C₅H₅)₂.

5. The apparatus of any one of the claims 1-4, wherein the chamber has a pressure less than 1 Torr when performing the hot-wire assisted and plasma-assisted pre-cleaning process and the hot-wire assisted atomic layer deposition process.

6. A method for manufacturing a semiconductor device, comprising:
(a) providing a substrate comprising a dielectric layer and a conductive layer in the dielectric layer, the conductive layer having an exposed upper surface;
(b) forming an interlayer dielectric layer having an opening exposing a portion of the exposed upper surface of the conductive layer;
(c) performing a hot-wire assisted plasma-assisted pre-cleaning process on the substrate;
(d) after the pre-cleaning process has been performed, performing a hot-wire assisted atomic deposition process to form a buffer barrier layer on the exposed portion of the upper surface of the conductive layer and on sidewalls of the opening;
(e) forming a metal material on the buffer barrier layer and filling the opening.

7. The method of claim 6, wherein
the buffer barrier layer comprises: a barrier layer configured to prevent the metal material from diffusing into the conductive layer and the interlayer dielectric layer; and a buffer layer on the barrier layer and configured to increase adhesion between the barrier layer and the metal material;
wherein preferably: the barrier layer is made of tantalum nitride, TaN; and performing a hot-wire assisted atomic deposition process comprises: a process gas comprising an ammoniac gas and a precursor containing tantalum, Ta; a hot wire at a temperature in a range between 900 °C and 1700 °C, wherein the precursor comprises Ta[N(CH₃)₂]₅.

8. The method of claim 7, wherein
the buffer layer is made of rubidium, Ru; and performing a hot-wire assisted atomic deposition process comprises: a process gas comprising an ammoniac gas and a precursor containing rubidium, Ru; and a hot wire having a temperature in a range between 900 °C and 1700 °C, wherein the precursor comprises Ru(C₅H₅)₂; or
the buffer layer is made of cobalt, Co; and performing a hot-wire assisted atomic deposition process comprises: a process gas comprising an ammoniac gas and a precursor containing cobalt, Co; and a hot wire at a temperature in a range between 900 °C and 1700 °C, wherein the precursor comprises Co(C₅H₅)₂.

9. The method of any one of the claims 6-8, wherein
the barrier layer is made of tantalum nitride, TaN; and
the buffer layer is made of cobalt, Co, or rubidium, Ru.

10. The method of any one of the claims 6-9, wherein forming the metal material comprises:
forming a metal seed layer on the buffer layer; and
plating a metal layer on the metal seed layer and filling the opening.

11. The method of any one of the claims 6-10, wherein forming the interlayer dielectric layer comprises:
forming a first interlayer dielectric layer made of a nitrogen-doped silicon carbide layer; and
forming a second interlayer dielectric layer made of a silicon-containing organic low-k dielectric layer on the first interlayer dielectric layer.

12. The method of any one of the claims 6-11, wherein performing the hot-wire assisted plasma-assisted pre-cleaning process comprises:
providing a process gas comprising hydrogen or nitrogen and hydrogen;
ionizing the process gas using a hot wire at a first temperature in a range between 900 °C and 1700 °C;
providing the ionized process gas to the substrate for cleaning the exposed portion of the upper surface of the conductive layer.

13. The method of claim 12, further comprising:
providing the substrate on a hot plate at a second temperature in a range between 150 °C and 400 °C when performing the hot-wire assisted plasma-assisted pre-cleaning process and the hot-wire assisted atomic deposition process.

14. The method of any one of the claims 6-11, wherein performing the hot-wire assisted atomic deposition process comprises:
providing a process gas comprising an ammoniac gas and a precursor gas containing a metal element;
ionizing the process gas using a hot wire having a temperature in a range between 900 °C and 1700 °C;
providing the ionized process gas to the substrate to form the buffer barrier layer.

15. The method of any one of the claims 6-14, wherein providing the process gas comprises four stages having a first stage providing helium and a precursor gas containing a metal element, a second stage providing helium, a third stage providing ammonia, NH₃, and a fourth stage providing helium.
